# EUROPEAN PATENT APPLICATION

(11) **EP 4 832 710 A1**
(43) Date of publication of application: **28.10.2026**
(21) Application number: 24906920.4
(22) Date of filing: 25.10.2024
(51) Int. Cl.: H10K 30/50, H10K 30/40, H10K 30/86, H10K 85/30, H10K 85/50, H10K 85/60

(54) **PHOTOELECTRIC CONVERSION ELEMENT AND PHOTOELECTRIC CONVERSION DEVICE**

(30) Priority: 21.12.2023 JP 2023216293; 28.05.2024 JP 2024086008
(71) Applicant: Canon Kabushiki Kaisha, Tokyo 146-8501 (JP)
(72) Inventor: SATO, Mizuki, Tokyo 146-8501 (JP); NISHIDA, Tsutomu, Tokyo 146-8501 (JP); NAKAMURA, Nobuhiro, Tokyo 146-8501 (JP); OHSAWA, Tatsuya, Tokyo 146-8501 (JP)
(74) Representative: TBK
(86) International application number: PCT/JP2024/038044
(87) International publication number: WO 2025/134532

(57) **Abstract**

An object is to provide a photoelectric conversion element using, as a hole-transporting material, a compound that exhibits satisfactory photoelectric conversion efficiency even when being dopant-free. In order to achieve the object, the present invention provides a photoelectric conversion element including: a first electrode; a second electrode; and a photoelectric conversion layer arranged between the first electrode and the second electrode, the photoelectric conversion layer containing a crystal having a perovskite structure, wherein the photoelectric conversion element includes, between the photoelectric conversion layer and the first electrode, a hole-transporting layer containing a compound represented by the formula (1).

## Description

### [Technical Field]

The present invention relates to a photoelectric conversion element and a photoelectric conversion apparatus.

### [Background Art]

In order to solve a problem of the depletion of fossil energy and a global environmental problem caused by the use of the fossil energy, investigations on a renewable and clean alternative energy source, such as solar energy, wind power, or water power, have been actively performed. In particular, an interest in a solar cell that directly changes sunlight into electrical energy has been increasing. The term "solar cell" as used herein means a battery that generates a current-voltage through utilization of a photovoltaic effect in which light energy is absorbed from sunlight to generate an electron and a hole.

Currently, an n-p diode-type silicon (Si) single crystal-based solar cell having a light energy conversion efficiency of more than 20% is widely known, and is actually used in solar power generation. However, the solar cell requires a high temperature treatment step and the price of a material itself is high, and hence there is a problem in that the cost per unit electric power is high. In addition, there is a problem with its supply property in terms of a silicon resource.

Meanwhile, a solar cell using an organic material (hereinafter also referred to as "organic solar cell") does not require the high temperature treatment step, and can be produced in a so-called roll to roll system using a sheet-shaped substrate. Accordingly, cost reduction can be expected. However, further improvements in power generation efficiency and durability have been desired for practical use of the organic solar cell. In particular, the development of a perovskite solar cell including a crystal having a perovskite structure as a photoelectric conversion layer toward its practical use has been advanced because the cell is excellent in photoelectric conversion property. In the perovskite solar cell, a hole-transporting material is often used in its element, and the hole-transporting material is used for the purpose of, for example, enhancing a function of selectively transporting holes to improve photoelectric conversion efficiency.

Spiro-OMeTAD, which is a spirobifluorene-based organic compound, is often used as a standard hole-transporting material, but the hole mobility and conductivity of pure Spiro-OMeTAD are relatively low. Accordingly, an additive, such as lithium bis(trifluoromethanesulfonyl)imide (LiTFSI) or 4-tert-butyl pyridine (TBP), that is, a dopant is added to improve the above-mentioned electronic properties. However, LiTFSI and TBP each have the following disadvantages: the compound promotes the deterioration of a battery because of its hygroscopicity and volatility; and the compound is not covalently bonded to the hole-transporting material and is hence liable to diffuse. Accordingly, LiTFSI and TBP are not suitable for device manufacturing, and the cost increases.

In view of the foregoing, the development of a hole-transporting material replacing Spiro-OMeTAD has been advanced in recent years. For example, in Patent Literature 1, there is a disclosure of a technology for obtaining a photoelectric conversion element that exhibits photoelectric conversion efficiency and durability higher than those of Spiro-OMeTAD by using a compound represented by the following formula (B-1) as a hole-transporting material.

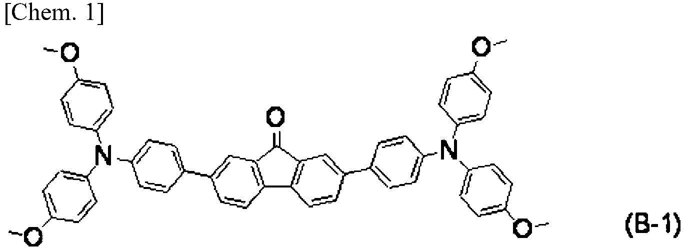

In addition, in Non Patent Literature 1, there is a report of an example in which a compound represented by the following formula (B-2) is used as a hole-transporting material, though the usage is for a dye-sensitized solar cell application.

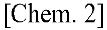

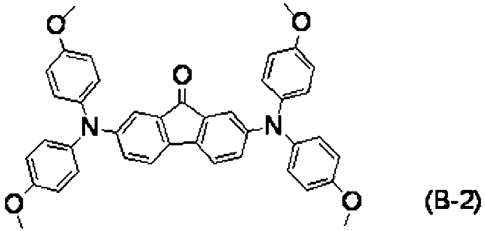

### [Citation List]

### [Patent Literature]

PTL 1: International Publication No. WO2022/153962

### [Non Patent Literature]

NPL 1: P. M. Lahti, et al, RSC Adv., 2013, 3, 15626-15629

### [Summary of Invention]

### [Technical Problem]

According to investigations made by the inventors of the present invention, the photoelectric conversion element described in Patent Literature 1 fails to show high electronic properties when being dopant-free, and there is room for improvement in conversion efficiency in the photoelectric conversion element described in Non Patent Literature 1. Accordingly, the present invention is directed to providing a photoelectric conversion element using, as a hole-transporting material, a compound that exhibits satisfactory photoelectric conversion efficiency even when being dopant-free. The present invention is also directed to providing a photoelectric conversion apparatus using, as a hole-transporting material, a compound that exhibits satisfactory photoelectric conversion efficiency even when being dopant-free.

### [Solution to Problem]

The above-mentioned provision of the photoelectric conversion element and the photoelectric conversion apparatus is achieved by the present invention described below. That is, a photoelectric conversion element according to the present invention is a photoelectric conversion element including: a first electrode; a second electrode; and a photoelectric conversion layer arranged between the first electrode and the second electrode, the photoelectric conversion layer containing a crystal having a perovskite structure, wherein the photoelectric conversion element includes, between the photoelectric conversion layer and the first electrode, a hole-transporting layer containing a compound represented by the following formula (1): 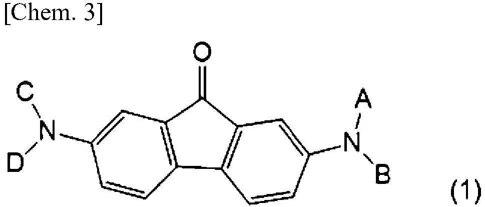 in the formula (1), A represents 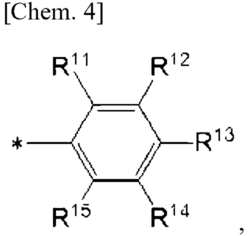 B represents 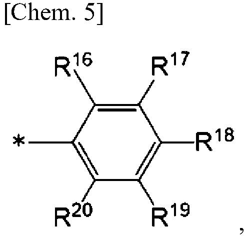 C represents 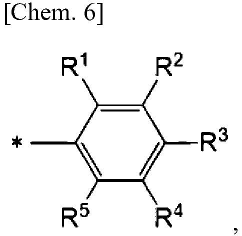 and D represents 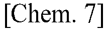 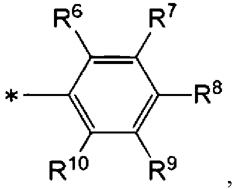 and R¹ to R²⁰ in the A to the D each independently represent a hydrogen atom, a trimethylsilyl group, a linear or branched alkyl group having 1 to 20 carbon atoms that may have a substituent, a linear or branched alkenyl group having 2 to 20 carbon atoms that may have a substituent, a cycloalkyl group having 3 to 10 carbon atoms that may have a substituent, an alkoxy group having 1 to 20 carbon atoms that may have a substituent, a cycloalkoxy group having 3 to 10 carbon atoms that may have a substituent, an alkylthio group or arylthio group having 1 to 18 carbon atoms that may have a substituent, a (di)alkylamino group or (di)arylamino group having 1 to 20 carbon atoms that may have a substituent, an aromatic hydrocarbon group having 6 to 36 carbon atoms that has a substituent, or a heterocyclic group having 5 to 36 ring-forming atoms that may have a substituent, and * in each of the formulae represents a bonding position with the formula (1), provided that the A and the B are different from each other, and the C and the D are different from each other.

### [Advantageous Effects of Invention]

According to the present invention, the photoelectric conversion element that exhibits satisfactory photoelectric conversion efficiency even when being dopant-free can be provided.

### [Brief Description of Drawings]

[Fig. 1]

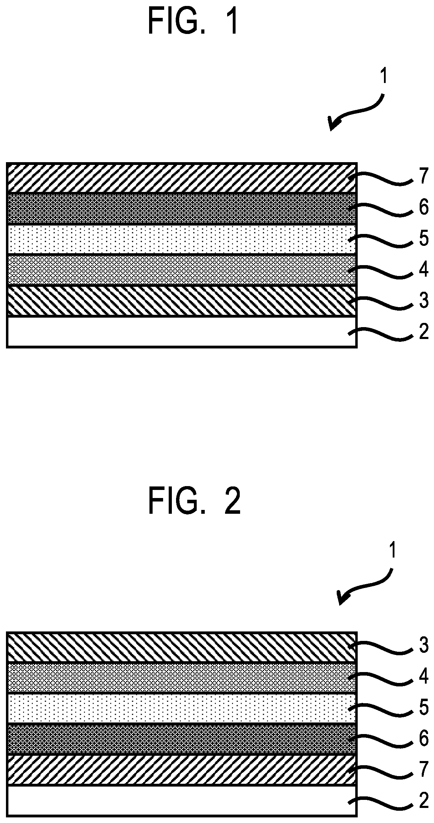

   Fig. 1 is a schematic sectional view in the thickness direction of a photoelectric conversion element according to a first embodiment of the present invention.
[Fig. 2]
   Fig. 2 is a schematic sectional view in the thickness direction of a photoelectric conversion element according to a second embodiment of the present invention.
[Fig. 3]

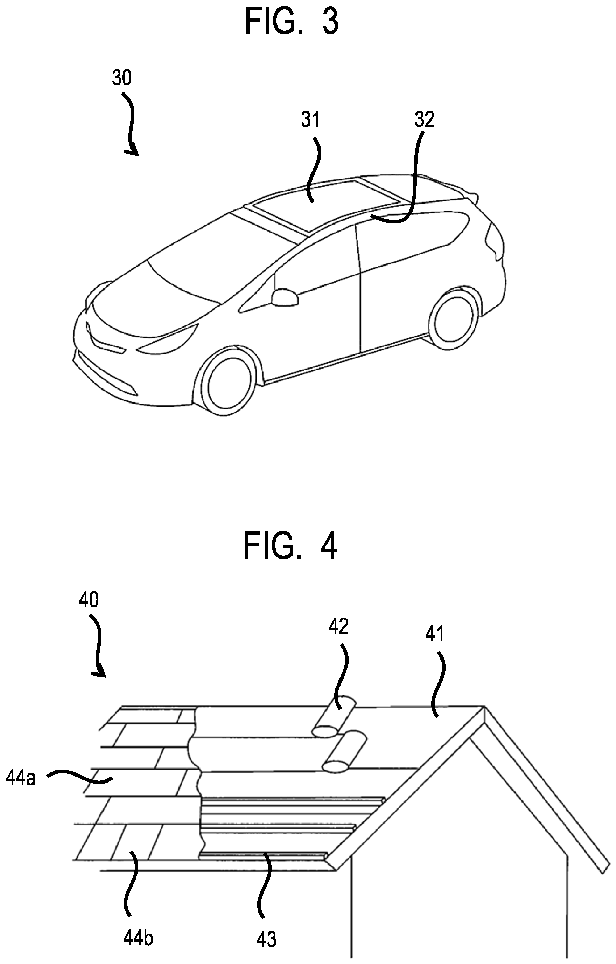

   Fig. 3 is a perspective view for schematically illustrating a moving body including the photoelectric conversion element according to one embodiment of the present invention.
[Fig. 4]
   Fig. 4 is a perspective view for schematically illustrating a building material including the photoelectric conversion element according to one embodiment of the present invention.

### [Description of Embodiments]

The present invention has the following gist. A photoelectric conversion element including: a first electrode; a second electrode; and a photoelectric conversion layer arranged between the first electrode and the second electrode, the photoelectric conversion layer containing a crystal having a perovskite structure, wherein the photoelectric conversion element includes, between the photoelectric conversion layer and the first electrode, a hole-transporting layer containing a compound represented by the following formula (1): 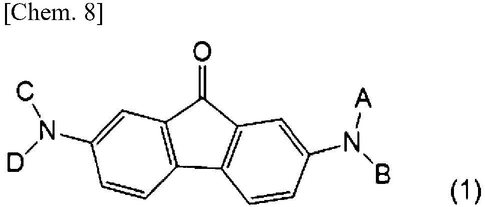 in the formula (1), A represents 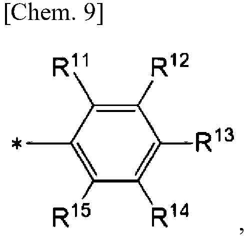 B represents 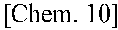 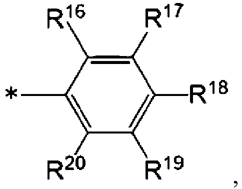 C represents 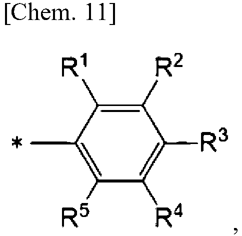 and D represents 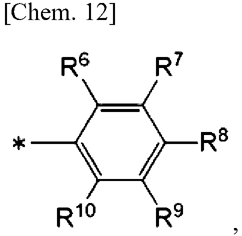 and R¹ to R²⁰ in the A to the D each independently represent a hydrogen atom, a trimethylsilyl group, a linear or branched alkyl group having 1 to 20 carbon atoms that may have a substituent, a linear or branched alkenyl group having 2 to 20 carbon atoms that may have a substituent, a cycloalkyl group having 3 to 10 carbon atoms that may have a substituent, an alkoxy group having 1 to 20 carbon atoms that may have a substituent, a cycloalkoxy group having 3 to 10 carbon atoms that may have a substituent, an alkylthio group or arylthio group having 1 to 18 carbon atoms that may have a substituent, a (di)alkylamino group or (di)arylamino group having 1 to 20 carbon atoms that may have a substituent, an aromatic hydrocarbon group having 6 to 36 carbon atoms that has a substituent, or a heterocyclic group having 5 to 36 ring-forming atoms that may have a substituent, and * in each of the formulae represents a bonding position with the formula (1), provided that the A and the B are different from each other, and the C and the D are different from each other.

As a result of investigations made by the inventors of the present invention, it has been found that, when the photoelectric conversion element includes the above-mentioned hole-transporting layer, the photoelectric conversion element is excellent in conversion efficiency even when being dopant-free. The details of the reason why higher conversion efficiency can be obtained in the present invention than that in the case of using a known compound are not clear, but a possible reason is as described below.

It is assumed that, when a donor-acceptor-donor (DAD) type organic low molecule having a fluorenone structure in an acceptor moiety is used as a hole-transporting material, the photoelectric conversion element can achieve high photoelectric conversion efficiency even when being dopant-free from the viewpoints of an increase in carrier density, energy matching with a lower layer, and passivation with the crystal having a perovskite structure in the photoelectric conversion layer. In addition, the photoelectric conversion element may include, between the photoelectric conversion layer and the hole-transporting layer containing the organic low molecule as a hole-transporting material, an intermediate layer containing a phthalocyanine particle. It is assumed that hysteresis is improved by an improvement in film adhesiveness because the DAD type organic low molecule having a fluorenone structure in the acceptor moiety is excellent in compatibility with the phthalocyanine particle.

According to investigations made by the inventors of the present invention, in the compound represented by the formula (B-1), which is a DAD type organic low molecule having a fluorenone structure in an acceptor moiety, the distribution of the HOMO is biased to a donor moiety because a nitrogen atom of diphenylamine of the donor moiety is not adjacent to the acceptor moiety. Accordingly, it is conceived that the compound has a low hole-transporting ability when being dopant-free. In addition, similarly, it has been found that in the compound represented by the formula (B-2), which is a DAD type organic low molecule having a fluorenone structure in the acceptor moiety, there is room to further cause the bias of an electron density because substituents of the donor moiety are unified only with methoxy groups.

In view of the foregoing, in the present invention, the photoelectric conversion efficiency can be improved by using, as the hole-transporting material, the compound represented by the formula (1) in which the A to the D in the formula (1) are such that the A and the B are different from each other, and the C and the D are different from each other. The inventors of the present invention have presumed that, when the nitrogen atom of diphenylamine of the donor moiety is adjacent to the acceptor moiety, the HOMO spreads and the hole-transporting ability is improved. In addition, the HOMO level of the entire molecule becomes shallower, and the donor property is improved. Further, it is assumed that the bias of the electron density of the donor moiety is strengthened and an increase in carrier density of the entire molecule is promoted by introducing different substituents into two phenyl groups bonded to the same nitrogen atom, respectively.

In the formula (1), the A to the D are preferably such that the A and the B are different from each other, the C and the D are different from each other, the A and the C are identical to each other, and the B and the D are identical to each other in order to spread the distribution of the HOMO evenly to the left and the right, and improve the transportation efficiency of a carrier.

In the present invention, it is preferred that R¹ to R²⁰ in the A to the D each independently represent a hydrogen atom, a linear or branched alkyl group having 1 to 20 carbon atoms that may have a substituent, an alkoxy group having 1 to 20 carbon atoms that may have a substituent, an alkylthio group or arylthio group having 1 to 18 carbon atoms that may have a substituent, or a (di)alkylamino group or (di)arylamino group having 1 to 20 carbon atoms that may have a substituent because an increase in carrier density is expected by a substituent having a strong donor property.

In particular, when the bias of the electron density easily occurs in the donor moiety, the photoelectric conversion efficiency in the case where the hole-transporting material is used for the photoelectric conversion element is satisfactory, and hence it is more preferred that R¹, R², R⁴, R⁵, R⁶, R⁷, R⁹, R¹⁰, R¹¹, R¹², R¹⁴, R¹⁵, R¹⁶, R¹⁷, R¹⁹, and R²⁰ each represent a hydrogen atom, and R³, R⁸, R¹³, and R¹⁸ satisfy the following conditions.

When R³ and R¹³ each represent a hydrogen atom, R⁸ and R¹⁸ each preferably represent a linear or branched alkyl group having 1 to 20 carbon atoms that may have a substituent, an alkoxy group having 1 to 20 carbon atoms that may have a substituent, a (di)alkylamino group or (di)arylamino group having 1 to 20 carbon atoms that may have a substituent, or an alkylthio group or arylthio group having 1 to 18 carbon atoms that may have a substituent.

When R³ and R¹³ each represent a linear or branched alkyl group having 1 to 20 carbon atoms that may have a substituent, R⁸ and R¹⁸ each preferably represent an alkoxy group having 1 to 20 carbon atoms that may have a substituent, a (di)alkylamino group or (di)arylamino group having 1 to 20 carbon atoms that may have a substituent, or an alkylthio group or arylthio group having 1 to 18 carbon atoms that may have a substituent.

When R³ and R¹³ each represent a linear or branched alkoxy group having 1 to 20 carbon atoms that may have a substituent, R⁸ and R¹⁸ each preferably represent a (di)alkylamino group or (di)arylamino group having 1 to 20 carbon atoms that may have a substituent.

When R³ and R¹³ each represent an alkylthio group or an arylthio group having 1 to 20 carbon atoms that may have a substituent, R⁸ and R¹⁸ each preferably represent a (di)alkylamino group or (di)arylamino group having 1 to 20 carbon atoms that may have a substituent.

In the formula (1), when the phenyl group in the A is free of a substituent, the phenyl group in the B preferably has a linear or branched alkyl group having 1 to 20 carbon atoms that may have a substituent, an alkoxy group having 1 to 20 carbon atoms that may have a substituent, a (di)alkylamino group or (di)arylamino group having 1 to 20 carbon atoms that may have a substituent, or an alkylthio group or arylthio group having 1 to 18 carbon atoms that may have a substituent from the viewpoint of further enhancing the photoelectric conversion efficiency.

In the formula (1), when the phenyl group in the A has a linear or branched alkyl group having 1 to 20 carbon atoms that may have a substituent, the phenyl group in the B preferably has an alkoxy group having 1 to 20 carbon atoms that may have a substituent, a (di)alkylamino group or (di)arylamino group having 1 to 20 carbon atoms that may have a substituent, or an alkylthio group or arylthio group having 1 to 18 carbon atoms that may have a substituent from the viewpoint of further enhancing the photoelectric conversion efficiency.

In the formula (1), when the phenyl group in the A has a linear or branched alkoxy group having 1 to 20 carbon atoms that may have a substituent, the phenyl group in the B preferably has a (di)alkylamino group or (di)arylamino group having 1 to 20 carbon atoms that may have a substituent from the viewpoint of further enhancing the photoelectric conversion efficiency.

In the formula (1), when the phenyl group in the A has an alkylthio group or arylthio group having 1 to 18 carbon atoms that may have a substituent, the phenyl group in the B preferably has a (di)alkylamino group or (di)arylamino group having 1 to 20 carbon atoms that may have a substituent from the viewpoint of further enhancing the photoelectric conversion efficiency.

The compound represented by the formula (1) serving as the hole-transporting material to be used for the hole-transporting layer of the photoelectric conversion element of the present invention is specifically described below, but the present invention is not limited thereto.

R¹ to R²⁰ in the A to the D in the formula (1) each independently represent a hydrogen atom, a trimethylsilyl group, a linear or branched alkyl group having 1 to 20 carbon atoms that may have a substituent, a linear or branched alkenyl group having 2 to 20 carbon atoms that may have a substituent, a cycloalkyl group having 3 to 10 carbon atoms that may have a substituent, an alkoxy group having 1 to 20 carbon atoms that may have a substituent, a cycloalkoxy group having 3 to 10 carbon atoms that may have a substituent, an alkylthio group or arylthio group having 1 to 18 carbon atoms that may have a substituent, a (di)alkylamino group or (di)arylamino group having 1 to 20 carbon atoms that may have a substituent, an aromatic hydrocarbon group having 6 to 36 carbon atoms that has a substituent, or a heterocyclic group having 5 to 36 ring-forming atoms that may have a substituent.

Examples of the "linear or branched alkyl group having 1 to 20 carbon atoms" in the "linear or branched alkyl group having 1 to 20 carbon atoms that may have a substituent" represented by each of R¹ to R²⁰ may include a methyl group, an ethyl group, a n-propyl group, an isopropyl group, a n-butyl group, an isobutyl group, a s-butyl group, a t-butyl group, a n-pentyl group, an isopentyl group, a n-hexyl group, a 2-ethylhexyl group, a heptyl group, an octyl group, an isooctyl group, a nonyl group, and a decyl group.

Examples of the "linear or branched alkenyl group having 2 to 20 carbon atoms" in the "linear or branched alkenyl group having 2 to 20 carbon atoms that may have a substituent" represented by each of R¹ to R²⁰ may include a vinyl group, a 1-propenyl group, an allyl group, a 1-methylethenyl group, a 1-butenyl group, a 2-butenyl group, a 1-pentenyl group, a 1-hexenyl group, a 2-methyl-1-propenyl group, a 2-methyl-2-propenyl group, and a 1-ethylethenyl group, and a linear or branched alkenyl group having 2 to 20 carbon atoms in which a plurality of those alkenyl groups are bonded to each other.

Examples of the "cycloalkyl group having 3 to 10 carbon atoms" in the "cycloalkyl group having 3 to 10 carbon atoms that may have a substituent" represented by each of R¹ to R²⁰ may include a cyclopropyl group, a cyclobutyl group, a cyclopentyl group, a cyclohexyl group, a cycloheptyl group, a cyclooctyl group, a cyclodecyl group, a cyclododecyl group, a 4-methylcyclohexyl group, and a 4-ethylcyclohexyl group.

Examples of the "alkoxy group having 1 to 20 carbon atoms" in the "alkoxy group having 1 to 20 carbon atoms that may have a substituent" represented by each of R¹ to R²⁰ may include a methoxy group, an ethoxy group, a propoxy group, a n-butoxy group, a n-pentyloxy group, a n-hexyloxy group, a heptyloxy group, an octyloxy group, a nonyloxy group, a decyloxy group, an isopropoxy group, an isobutoxy group, a s-butoxy group, a t-butoxy group, an isooctyloxy group, a t-octyloxy group, a phenoxy group, a tolyloxy group, a biphenylyloxy group, a terphenylyloxy group, a naphthyloxy group, an anthryloxy group, a phenanthryloxy group, a fluorenyloxy group, and an indenyloxy group.

Examples of the "linear or branched cycloalkoxy group having 3 to 10 carbon atoms" in the "cycloalkoxy group having 3 to 10 carbon atoms that may have a substituent" represented by each of R¹ to R²⁰ may include a cyclopropoxy group, a cyclobutoxy group, a cyclopentyloxy group, a cyclohexyloxy group, and a 4-methylcyclohexyloxy group.

Examples of the "alkylthio group or arylthio group having 1 to 18 carbon atoms" in the "alkylthio group or arylthio group having 1 to 18 carbon atoms that may have a substituent" represented by each of R¹ to R²⁰ may include a methylthio group, an ethylthio group, a propylthio group, a phenylthio group, and a biphenylthio group.

Examples of the "(di)alkylamino group or (di)arylamino group having 1 to 20 carbon atoms" in the "(di)alkylamino group or (di)arylamino group having 1 to 20 carbon atoms that may have a substituent" represented by each of R¹ to R²⁰ may include: monosubstituted amino groups, such as an ethylamino group and a phenylamino group; and disubstituted amino groups, such as a diethylamino group and a diphenylamino group. In addition, an acetylamino group, an acetylphenylamino group, and the like may be selected in addition to the above-mentioned amino groups.

Examples of the "aromatic hydrocarbon group having 6 to 36 carbon atoms" in the "aromatic hydrocarbon group having 6 to 36 carbon atoms that may have a substituent" represented by each of R¹ to R²⁰ may include a phenyl group, a biphenyl group, a terphenyl group, a naphthyl group, a biphenyl group, an anthracenyl group (anthryl group), a phenanthryl group, a fluorenyl group, an indenyl group, a pyrenyl group, a perylenyl group, a fluoranthenyl group, and a triphenylenyl group. In the present invention, the aromatic hydrocarbon group encompasses a "condensed polycyclic aromatic group."

Examples of the "heterocyclic group having 5 to 36 ring-forming atoms" in the "heterocyclic group having 5 to 36 ring-forming atoms that may have a substituent" represented by each of R¹ to R²⁰ may include a pyridyl group, a pyrimidinyl group, a triazinyl group, a morpholino group, a thienyl group, a furyl group (furanyl group), a pyrrolyl group, an imidazolyl group, a pyrazolyl group, a triazolyl group, a quinolyl group, an isoquinolyl group, a naphthyridinyl group, an acridinyl group, a phenanthrolinyl group, a benzofuranyl group, a benzothienyl group, an oxazolyl group, an indolyl group, a carbazolyl group, a benzoxazolyl group, a thiazolyl group, a benzothiazolyl group, a quinoxalinyl group, a benzimidazolyl group, a pyrazolyl group, a dibenzofuranyl group, and a dibenzothienyl group.

Examples of the "substituent" in the "linear or branched alkyl group having 1 to 18 carbon atoms that may have a substituent," the "linear or branched alkenyl group having 2 to 20 carbon atoms that may have a substituent," the "cycloalkyl group having 3 to 10 carbon atoms that may have a substituent," the "alkoxy group having 1 to 20 carbon atoms that may have a substituent," the "cycloalkoxy group having 3 to 10 carbon atoms that may have a substituent," the "acyl group having 1 to 20 carbon atoms that may have a substituent," the "alkylthio group or arylthio group having 1 to 18 carbon atoms that may have a substituent," the "(di)alkylamino group or (di)arylamino group having 1 to 20 carbon atoms that may have a substituent," the "aromatic hydrocarbon group having 6 to 36 carbon atoms that has a substituent," or the "heterocyclic group having 5 to 36 ring-forming atoms that may have a substituent" represented by each of R¹ to R²⁰ may include: a trimethylsilyl group; linear or branched alkyl groups each having 1 to 18 carbon atoms, such as a methyl group, an ethyl group, a n-propyl group, an isopropyl group, a n-butyl group, an isobutyl group, a s-butyl group, a t-butyl group, a n-pentyl group, an isopentyl group, a n-hexyl group, a 2-ethylhexyl group, a heptyl group, an octyl group, an isooctyl group, a nonyl group, and a decyl group; linear or branched alkenyl groups each having 2 to 18 carbon atoms, such as an ethenyl group (vinyl group), a 1-propenyl group, a 2-propenyl group (allyl group), a 1-butenyl group, a 2-butenyl group, a 1-pentenyl group, a 1-hexenyl group, a 2-methyl-1-propenyl group, a 2-methyl-2-propenyl group, and a 1-ethylethenyl group; alkoxy groups each having 1 to 18 carbon atoms, such as a methoxy group, an ethoxy group, a propoxy group, a t-butoxy group, a pentyloxy group, and a hexyloxy group; aromatic hydrocarbon groups each having 6 to 30 carbon atoms, such as a phenyl group, a naphthyl group, an anthryl group, a phenanthryl group, and a pyrenyl group; heterocyclic groups each having 5 to 30 ring-forming atoms, such as a pyridyl group, a pyrimidinyl group, a triazinyl group, a thienyl group, a furyl group (furanyl group), a pyrrolyl group, an imidazolyl group, a pyrazolyl group, a triazolyl group, a quinolyl group, an isoquinolyl group, a naphthyridinyl group, an acridinyl group, a phenanthrolinyl group, a benzofuranyl group, a benzothienyl group, an oxazolyl group, an indolyl group, a carbazolyl group, a benzoxazolyl group, a thiazolyl group, a benzothiazolyl group, a quinoxalinyl group, a benzimidazolyl group, a pyrazolyl group, a dibenzofuranyl group, and a dibenzothienyl group; monosubstituted amino groups, such as an amino group (-NH₂), an ethylamino group, an acetylamino group, and a phenylamino group, and disubstituted amino groups, such as a diethylamino group, a diphenylamino group, and an acetylphenylamino group; and a thiol group: -SH, a methylthio group, an ethylthio group, a propylthio group, a phenylthio group, and a biphenylthio group. A plurality of those "substituents" may be included, and when a plurality of the "substituents" are included, the "substituents" may be identical to or different from each other. In addition, those "substituents" may each further have the substituents given as examples above.

Further, in the formula (1), the A to the D each preferably have, at one position of an ortho position or a para position, one kind of a hydrogen atom, a linear or branched alkyl group having 1 to 20 carbon atoms that may have a substituent, an alkoxy group having 1 to 20 carbon atoms that may have a substituent, a (di)alkylamino group or (di)arylamino group having 1 to 20 carbon atoms that may have a substituent, or an alkylthio group or arylthio group having 1 to 18 carbon atoms that may have a substituent.

Specific examples of the compound represented by the formula (1) of the present invention are shown in Table 1, but the present invention is not limited thereto. In Table 1, the A to the D represent the A to the D in the formula (1), and a substituent description section represents a substituent on a phenyl group. In Table 1, "no substituent" and R¹ to R²⁰ except those described in the table each represent a hydrogen atom.

### [Table 1]

**Table 1**

| Compound | A | B | C | D |
|---|---|---|---|---|
| A-1 | No substituent | R¹⁸ represents methyl group | No substituent | R⁸ represents methyl group |
| A-2 | No substituent | R¹⁸ represents t-butyl group | No substituent | R⁸ represents t-butyl group |
| A-3 | No substituent | R¹⁸ represents methylthio group | No substituent | R⁸ represents methylthio group |
| A-4 | No substituent | R¹⁸ represents methoxy group | No substituent | R⁸ represents methoxy group |
| A-5 | No substituent | R¹⁸ represents hexyloxy group | No substituent | R⁸ represents hexyloxy group |
| A-6 | No substituent | R¹⁸ represents dimethylamino group | No substituent | R⁸ represents dimethylamino group |
| A-7 | R¹³ represents methyl group | R¹⁸ represents methylthio group | R³ represents methyl group | R⁸ represents methylthio group |
| A-8 | R¹³ represents methyl group | R¹⁸ represents methoxy group | R³ represents methyl group | R⁸ represents methoxy group |
| A-9 | R¹³ represents methyl group | R¹⁸ represents dimethylamino group | R³ represents methyl group | R⁸ represents dimethylamino group |
| A-10 | R¹³ represents methoxy group | R¹⁸ represents dimethylamino group | R³ represents methoxy group | R⁸ represents dimethylamino group |
| A-11 | R¹³ represents methylthio group | R¹⁸ represents dimethylamino group | R³ represents methylthio group | R⁸ represents dimethylamino group |
| A-12 | R¹³ represents methylthio group | R¹⁸ represents methoxy group | R³ represents methylthio group | R⁸ represents methoxy group |
| A-13 | R¹³ and R¹⁴ each represent methyl group | R¹⁸ represents methyl group | R³ and R⁴ each represent methyl group | R⁸ represents methyl group |
| A-14 | R¹³ and R¹⁴ each represent methoxy group | R¹⁸ represents methoxy group | R³ and R⁴ each represent methoxy group | R⁸ represents methoxy group |
| A-15 | No substituent | R¹⁸ represents vinyl group | No substituent | R⁸ represents vinyl group |
| A-16 | No substituent | R¹⁸ represents morpholino group | No substituent | R⁸ represents morpholino group |
| A-17 | No substituent | R¹⁸ represents cyclohexyl group | No substituent | R⁸ represents cyclohexyl group |
| A-18 | No substituent | R¹⁸ represents phenyl group | No substituent | R⁸ represents phenyl group |
| A-19 | No substituent | R¹⁸ represents trimethylsilyl group | No substituent | R⁸ represents trimethylsilyl group |
| A-20 | R¹³ represents cyclohexyl group | R¹⁸ represents methylthio group | R³ represents cyclohexyl group | R⁸ represents methylthio group |
| A-21 | R¹³ represents trimethylsilyl group | R¹⁸ represents methylthio group | R³ represents trimethylsilyl group | R⁸ represents methylthio group |
| A-22 | R¹³ represents methyl group | R¹⁸ represents methylthio group | R³ represents methoxy group | R⁸ represents methylthio group |
| A-23 | No substituent | R¹⁸ represents methyl group | R³ represents methoxy group | R⁸ represents methyl group |

In the present invention, the compound represented by the formula (1) is more preferably any one selected from the group consisting of: a compound represented by the following formula (A-8); a compound represented by the following formula (A-12); a compound represented by the following formula (A-14); a compound represented by the following formula (A-16); and a compound represented by the following formula (A-23).

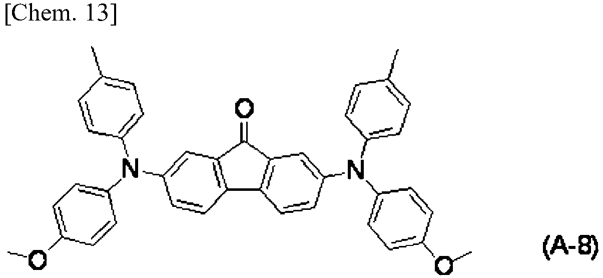

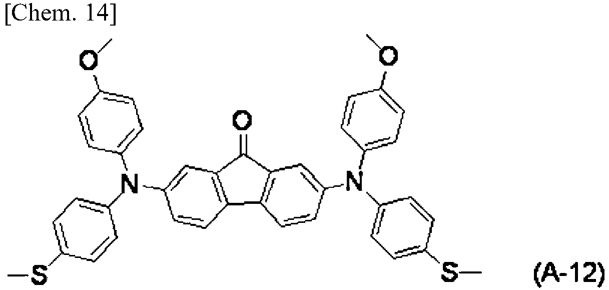

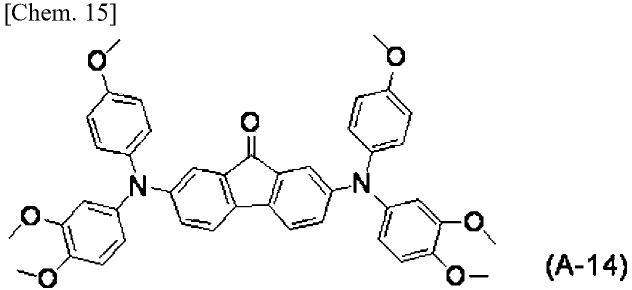

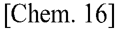

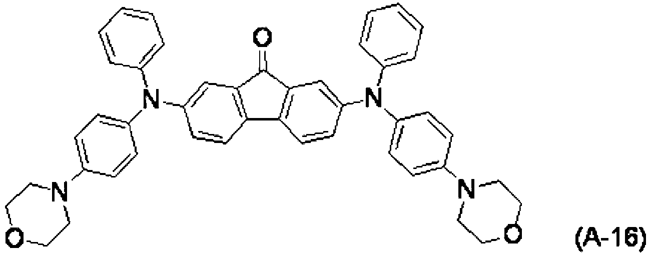

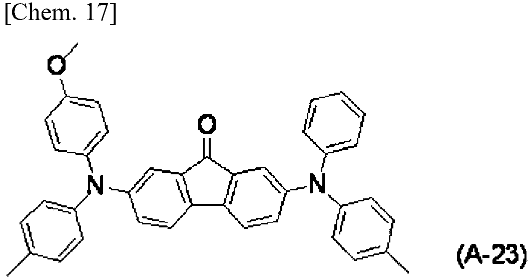

The compound represented by the formula (1) may be synthesized by a known method. For example, the compound may be synthesized by the Buchwald-Hartwig cross-coupling reaction of 2,7-dibromofluorenone represented by the following formula (2), and an amine compound represented by each of the following general formulae (3) and (4). 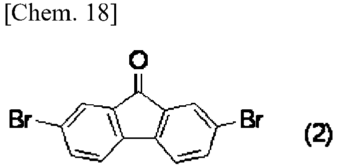 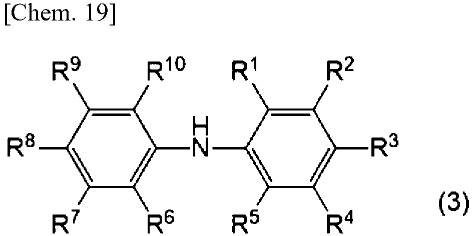 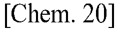 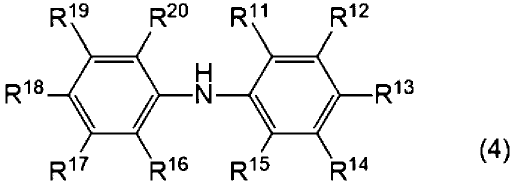 R¹ to R²⁰ in the formulae (3) and (4) are the same as R¹ to R²⁰ in the formula (1).

A method of purifying the compound represented by the formula (1) may be, for example, purification by column chromatography, adsorption purification with silica gel, activated carbon, or activated clay, or purification by recrystallization or crystallization with a solvent. Alternatively, it is effective to use a compound whose purity is increased by using those methods in combination. In addition, those compounds may be identified by nuclear magnetic resonance analysis (NMR).

The present invention is described in detail below by way of preferred embodiments. The present invention is not limited to the following embodiments, and the following embodiments, which are appropriately changed, modified, and the like based on the ordinary knowledge of a person skilled in the art without departing from the gist of the present invention, are also encompassed within the scope of the present invention.

The term "layer" as used herein means not only a layer having a clear boundary or a layer having a flat thin film shape but also a layer having a concentration gradient in which the concentration of an element to be incorporated gradually changes, or a layer that may form a complicatedly intricate structure together with another layer. In addition, the elemental analysis of the layer may be performed by, for example, performing the TOF-SIMS/FE-TEM/EDS line analysis measurement of a cross section of the photoelectric conversion element and determining the element distribution of a specific element.

Fig. 1 is a sectional view for schematically illustrating the configuration of the photoelectric conversion element according to one embodiment of the present invention. A photoelectric conversion element 1 includes a substrate 2, and a second electrode 3, an electron-transporting layer 4, a photoelectric conversion layer 5, a hole-transporting layer 6, and a first electrode 7 arranged thereon. An intermediate layer 8 (not shown) may be formed between the photoelectric conversion layer 5 and the hole-transporting layer 6. One of the first electrode 7 and the second electrode 3 is an anode, and the other is a cathode. A current can be extracted by connecting the first electrode 7 and the second electrode 3 with an external circuit.

The photoelectric conversion layer 5 is excited by light that has entered the layer through: the substrate 2, the second electrode 3, and the electron-transporting layer 4; the first electrode 7 and the hole-transporting layer 6; or the first electrode 7, the hole-transporting layer 6, and the intermediate layer 8 (not shown) to generate electrons or holes. That is, the photoelectric conversion layer 5 generates a current between the first electrode 7 and the second electrode 3. The electron-transporting layer 4 is a layer arranged between the photoelectric conversion layer 5, and the two electrodes 3 and 7, and does not need to be formed in some cases. A form in which a plurality of the electron-transporting layers 4 and the photoelectric conversion layers 5 are laminated may be adopted. Such form may also be referred to as "tandem structure." The respective members are described below. In addition, as illustrated in Fig. 2, the photoelectric conversion element may be produced in the order of the first electrode 7, the hole-transporting layer 6, the photoelectric conversion layer 5, the electron-transporting layer 4, and the second electrode 3 on the substrate 2. The intermediate layer 8 (not shown) may be formed between the hole-transporting layer 6 and the photoelectric conversion layer 5.

### [Photoelectric Conversion Element]

The photoelectric conversion element of the present invention is a photoelectric conversion element including: a first electrode; a second electrode; and a photoelectric conversion layer arranged between the first electrode and the second electrode, the photoelectric conversion layer containing a crystal having a perovskite structure, wherein the photoelectric conversion element includes, between the photoelectric conversion layer and the first electrode, a hole-transporting layer containing the compound represented by the formula (1). In addition, in order to improve the photoelectric conversion efficiency, a tandem type in which the photoelectric conversion elements are laminated may be adopted. The kind of the photoelectric conversion element to be laminated is not limited, and for example, a silicon solar cell or a CIGS solar cell may be adopted in addition to a perovskite solar cell using a crystal having a perovskite structure in its photoelectric conversion layer.

A method of forming each of the layers including the photoelectric conversion layer of the photoelectric conversion element of the present invention is, for example, a coating method or a vapor deposition method. Examples of the coating method include dip coating, spin coating, spray coating, ink jet coating, meniscus coating, screen coating, roll coating, die coating, blade coating, curtain coating, and wire bar coating. The coating method is a method including preparing a coating liquid for each layer to be described later, applying the liquid in the desired order of layers, and drying the liquid. A desired method may be selected as such forming method in accordance with each layer.

The substrate and the respective layers are described below.

### [Substrate]

The photoelectric conversion element 1 of the present invention may include the substrate 2, and examples thereof include a transparent glass substrate made of soda-lime glass or alkali-free glass, a ceramic substrate, and a transparent plastic substrate. When light is taken in from the first electrode 7 side, an opaque material may be used as the substrate 2, and when light is taken in from the second electrode 3 side, the substrate 2 is formed of a transparent material.

### [Electrode]

A material for the first electrode 7 or the second electrode 3 is not particularly limited, and a material that has hitherto been known may be used. Examples thereof include: metals, such as gold, silver, titanium, and copper; sodium; a sodium-potassium alloy; lithium; magnesium; carbon; a carbon nanotube; aluminum; a magnesium-silver mixture; a magnesium-indium mixture; an aluminum-lithium alloy; an Al/Al₂O₃ mixture; and an Al/LiF mixture.

Examples of a transparent electrode material include: conductive transparent materials, such as CuI, indium tin oxide (ITO), SnO₂, aluminum zinc oxide (AZO), indium zinc oxide (IZO), gallium zinc oxide (GZO), fluorine-doped tin oxide (FTO), and antimony-doped tin oxide (ATO); and conductive transparent polymers. Those materials may be used alone or in combination thereof.

At least one electrode of the first electrode 7 or the second electrode 3 on a light incident side is a transparent electrode, and the other may be a transparent electrode or may also serve as a reflective layer formed of a light reflective material, or may be a transparent electrode including a reflective layer on a side opposite to the light incident side. When the first electrode 7 is on the light incident side, the second electrode 3 and the substrate 2 may be a transparent electrode and a reflective layer, respectively. The transparent electrode may be a patterned electrode.

### [Photoelectric Conversion Layer]

The photoelectric conversion element of the present invention includes a photoelectric conversion layer arranged between the first electrode and the second electrode, the photoelectric conversion layer containing a crystal having a perovskite structure. The photoelectric conversion layer 5 contains a crystal having a perovskite structure. The crystal having a perovskite structure to be used in the present invention is preferably represented by the following general formula [5].

ABX₃ [5]

In the general formula [5], A represents a monovalent cation of an organic molecule or a metal atom, B represents a divalent metal cation, and X represents a monovalent halide anion.

The A in the general formula [5] preferably represents CₚN_{q}Hᵣ ("p", "q", and "r" each represent a positive integer) in the case of, for example, the organic molecule. Specific examples thereof include methylammonium and formamidinium.

In addition, the metal atom is not particularly limited, and lithium, cesium, sodium, potassium, and rubidium are preferred. Those organic molecules or metal atoms may be used alone or in combination thereof.

When the cation A to be included is too large to fit in a crystal having a three-dimensional perovskite structure, a crystal having a two-dimensional perovskite structure, a crystal having a 2.5-dimensional perovskite structure with properties of both the two-dimensional and three-dimensional perovskite structures, a two-layer crystal having three-dimensional and two-dimensional perovskite structures, or a crystal having a mixed three-dimensional/two-dimensional perovskite structure is formed, and any of the structures functions as the photoelectric conversion layer. The two-layer crystal having three-dimensional and two-dimensional perovskite structures refers to a crystal in which the crystals having three-dimensional and two-dimensional perovskite structures are laminated as independent and separate layers. The crystal having a mixed three-dimensional/two-dimensional perovskite structure refers to a crystal having a structure in which both the regions or domains of crystals having two-dimensional or 2.5-dimensional layered and three-dimensional perovskite structures are mixed.

It is preferred that the crystal having a two-dimensional perovskite or 2.5-dimensional perovskite structure be represented by each of the following general formulae [6] to [8] ("n" represents a positive integer).

R'₂Aₙ₋₁BₙX₃ₙ₊₁ [6]

R"Aₙ₋₁BₙX₃ₙ₊₁ [7]

R‴AₙBₙX₃ₙ₊₁ [8]

The general formula [6], the general formula [7], and the general formula [8] form perovskite structures of a Ruddlesden-Popper (RP) type, a Dion-Jacobson (DJ) type, and an Alternating cations in the interlayer (ACI) type, respectively.

R', R", and R‴ in the general formulae [6] to [8] each represent a cation of an organic molecule or a metal that may have a substituent. Specifically, ethylammonium, propylammonium, n-butylammonium, n-hexylammonium, n-octylammonium, 1,6-hexadiammonium, iso-butylammonium, 3-(nonafluoro-tert-butyloxy)propylamine, 1,3-propanediammonium, 1,5-pentamethylenediamine, octyldiammonium, 2,2-(ethylenedioxy)bis(ethylammonium), 5-aminovaleric acid, 4-tert-butylammonium, N,N'-dimethylethylene-1,2-diammonium, 2,2,3,3,3-pentafluoropropylammonium, guanidinium, propylammonium, propargylamine, an alkylammonium, cyclohexylmethylammonium, 4-(aminomethyl)piperidinium, piperidinium, pyrrolidinium, cyclohexylammonium, 4-fluorophenethylammonium, 4-fluorophenethylammonium, trifluoromethylbenzylammonium, pentafluorobenzylammonium, pentafluorophenylethylammonium, 4-methoxyphenethylammonium, imidazolium, pyridinium, 3-thiophenemethylammonium, 2-thiopheneethylammonium, 2-thiopheneformamidinium, 2-thiophenemethylammonium, 1-naphthylmethylammonium, 2-naphthylmethylammonium, phenethylammonium, phenylammonium, benzylammonium, 2,5-thiophenedimethylammonium, phenylpropylammonium, 1,4-phenylenedimethanamine, 3-phenyl-2-propen-1-ammonium, phenylbutylammonium, 4-tert-butylbenzylammonium, 3-(aminomethyl)piperidinium, and 4-(aminomethyl)piperidinium are preferred.

B in each of the general formulae [5] to [8] represents a metal atom, and examples thereof include lead, tin, bismuth, zinc, titanium, antimony, nickel, iron, cobalt, silver, copper, gallium, germanium, magnesium, calcium, indium, aluminum, manganese, chromium, molybdenum, and europium. Of those, lead, tin, and bismuth are preferred from the viewpoint of the overlap of electron orbitals. Those metal atoms may be used alone or in combination thereof.

X in each of the general formulae [5] to [8] represents a halogen atom, and examples thereof include chlorine, bromine, and iodine. Those halogen atoms may be used alone or in combination thereof. Of those, a halogen atom is preferred because, when the halogen atom is incorporated into the structure, the above-mentioned crystal having a perovskite structure easily becomes soluble in an organic solvent, and hence its application to an inexpensive printing method or the like is enabled. Further, iodine is more preferred because the energy bandgap of the crystal having a perovskite structure narrows.

Specifically, as three-dimensional perovskite, two-dimensional perovskite, and mixed three-dimensional/two-dimensional perovskite, MAPbI₃, FAPbCl₃, FAPbI₃, MAPbIₓBr₃₋ₓ, MAPbIₓCl₃₋ₓ, Cs_{0.05}(MA_{0.17}FA_{0.83})_{0.95}Pb(I_{0.83}Br_{0.17})₃, {Csₓ₁(FAₓ₂MA₁₋ₓ₂)₁₋ₓ₁}ₓ₃Pb(Iₓ₄Br₁₋ₓ₄)ₓ₅, Cs_{0.05}FA_{0.88}MA_{0.07}PbI_{2.56}Br_{0.44}, (FAPbI₃)_{0.95}(MAPbBr₃)_{0.05}, (FAPbI₃)_{0.85}(MAPbBr₃)_{0.15}, CsPbI₃, CsPbBr₃, Csₓ(MA)₁₋ₓPbI₃, Csₓ(FA)₁₋ₓPbI₃, MAₓ(FA)₁₋ₓPbI₃, MA_{0.17}FA_{0.83}Pb(I_{0.83}Br_{0.17})₃, Cs0.15FA0.85PbI2.55Br0.45, Cs0.05FA0.88MA0.07PbI2.56Br0.44, Cs0.15FA0.85PbI2.55Br0.45, (PEA)₂(MA)₂Pb₃I₁₀, (PTA)₂(MA)₄Pb₅I₁₆, (PEA)₂(MA)₄Pb₅I₁₆, (ThMA)₂(MA)₂Pb₃I₁₀, (3BBA)₂(MA)₂Pb₃I₁₀, (ThMA)₂(FA)₄Pb₅I₁₆, (4FPEA)₂(FA_{0.3}MA_{0.7})₄Pb₅I₁₆, (PDMA)FA₂Pb₃I₁₀, (3AMPY)(MA)₃Pb₄I₁₃, (PDMA)MA₅Pb₆I₁₉, (PDMA)MA₃Pb₄I₁₃, (TTDMA)MA₃Pb₄I₁₃, (TTDMA)MA₄Pb₅I₁₆, (BA_{0.9}PEA_{0.1})₂MA₄Pb₅I₁₆, (BA_{0.9}PEA_{0.1})₂MA₃Pb₄I₁₃, (4FPEA)₂MA₃Pb₄I₁₃, (4FPEA)₂MA₄Pb₅I₁₆, (BA)₂MA₂Pb₃I₁₀, (BA)₂MA₃Pb₄I₁₃, (TEA)₂MA₂Pb₃I₁₀, (BA)₂MA₄Pb₅I₁₆, (BA)₂MA₃Pb₄I₁₃, CsSnBr₃, CsSnI₃, FA_{0.75}MA_{0.25}Sn_{0.95}Ge_{0.05}I₃, FAMASnGeI₃, FASnBr₃, FASnI₃, MA₂Sn₃I₈, MASnBr₃, MASnGeI₃, and MASnI₃ are preferred.

The A site, B site, or X site of each of the general formulae [5] to [8] may be adjusted to be deficient or excessive in accordance with purposes, and the combinations of x1 to x5 may be changed in accordance with purposes. Examples of the combinations of x1 to x5 are as shown in Table 2. Particularly preferred ranges of the combinations of x1 to x5 are 0.03≤x1≤0.10, 0.80≤x2≤0.96, 0.95≤x3≤1.05, 0.80≤x4≤0.96, and 2.95≤x5≤3.05. MACl may be incorporated as a material for forming a perovskite crystal.

### [Table 2]

**Table 2**

| x1 | x2 | 1-x2 | x3 | x4 | 1-x4 | x5 |
|---|---|---|---|---|---|---|
| 0.05 | 0.83 | 0.17 | 1.00 | 0.83 | 0.17 | 3.00 |
| 0.05 | 0.83 | 0.17 | 0.99 | 0.83 | 0.17 | 2.99 |
| 0.05 | 0.83 | 0.17 | 0.98 | 0.83 | 0.17 | 2.98 |
| 0.05 | 0.83 | 0.17 | 0.97 | 0.83 | 0.17 | 2.97 |
| 0.05 | 0.83 | 0.17 | 0.96 | 0.83 | 0.17 | 2.96 |
| 0.05 | 0.83 | 0.17 | 1.01 | 0.83 | 0.17 | 3.01 |
| 0.05 | 0.83 | 0.17 | 1.02 | 0.83 | 0.17 | 3.02 |
| 0.05 | 0.83 | 0.17 | 1.03 | 0.83 | 0.17 | 3.03 |
| 0.05 | 0.83 | 0.17 | 1.04 | 0.83 | 0.17 | 3.04 |
| 0.05 | 0.83 | 0.17 | 1.00 | 0.95 | 0.05 | 3.00 |
| 0.05 | 0.83 | 0.17 | 0.97 | 0.95 | 0.05 | 2.97 |
| 0.05 | 0.83 | 0.17 | 0.98 | 0.95 | 0.05 | 2.98 |
| 0.05 | 0.83 | 0.17 | 0.99 | 0.95 | 0.05 | 2.99 |
| 0.05 | 0.83 | 0.17 | 1.01 | 0.95 | 0.05 | 3.01 |
| 0.05 | 0.83 | 0.17 | 1.02 | 0.95 | 0.05 | 3.02 |
| 0.05 | 0.83 | 0.17 | 1.03 | 0.95 | 0.05 | 3.03 |

In the above-mentioned specific examples, "MA" represents methylammonium, "FA" represents formamidinium, "PEA" represents phenethylammonium, "PTA" represents phenyltriethylammonium, "ThMA" represents 2-thiophenemethylammonium, "3BBA" represents 3-bromobenzylammonium, "3AMPY" represents 3-(aminomethyl)pyridine, "PDMA" represents 1,4-phenylenedimethanammonium, "TTDMA" represents thieno[3,2-b]thiophene-2,5-diyldimethanammonium, "4FPEA" represents 4-fluorophenethylammonium, "BA" represents butylammonium, and "TEA" represents 2-thiopheneethylammonium.

The above-mentioned crystal having a perovskite structure preferably has a cubic structure in which the metal atom M, the organic molecules R, and the halogen atom or chalcogen atom X are arranged on a body-centered position, the respective corners, and a face-centered position, respectively. The details are not clear, but it is assumed that, when such structure is present, the orientation of an octahedron in a crystal lattice can be easily changed, and hence the mobility of an electron in the crystal having a perovskite structure increases, and the photoelectric conversion efficiency of the photoelectric conversion element is improved.

The crystal having a perovskite structure to be used in the present invention is preferably a crystalline semiconductor. The term "crystalline semiconductor" means a semiconductor that enables the measurement of an X-ray scattering intensity distribution to detect a scattering peak. When the crystal having a perovskite structure is the crystalline semiconductor, the mobility of the electron in the crystal having a perovskite structure increases, and the photoelectric conversion efficiency of the photoelectric conversion element is improved.

The thickness of the photoelectric conversion layer according to the present invention is preferably 5 to 2,000 nm. When the thickness is 5 nm or more, light can be sufficiently absorbed, and when the thickness is 2,000 nm or less, the generated charge can be transported to the respective electrodes. A more preferred lower limit is 50 nm, a more preferred upper limit is 1,200 nm, a still more preferred lower limit is 100 nm, and a still more preferred upper limit is 1,000 nm.

### [Hole-transporting Layer]

The photoelectric conversion element of the present invention includes the hole-transporting layer 6 between the photoelectric conversion layer and the first electrode 7. The hole-transporting layer 6 is a layer containing the compound represented by the formula (1) as a hole-transporting material. In the hole-transporting layer, two or more kinds of hole-transporting materials may be used in combination, or may be used in combination with, for example, any other hole-transporting material not belonging to the present invention. At that time, 50 wt% or more of the compound represented by the formula (1) is preferably incorporated as the hole-transporting material.

Examples of the other hole-transporting material not belonging to the present invention include a spirofluorene compound, a triphenylamine compound, a chrysene compound, a pyrene compound, a phthalocyanine compound, a carbazole compound, a fluorene compound, a phenylcyclohexane compound, a benzidine compound, a phenoxazine compound, a phenylenediamine compound, a thiocyanate compound, and a thiophene compound.

### [Electron-transporting Layer]

In the photoelectric conversion element of the present invention, the electron-transporting layer 4 may be arranged between the second electrode 3 and the photoelectric conversion layer 5 as illustrated in Fig. 1.

A material for the electron-transporting layer 4 is not particularly limited, and examples thereof include an N-type conductive polymer, an N-type low-molecular-weight organic semiconductor, an N-type metal oxide, an N-type metal sulfide, a halogenated alkali metal, an alkali metal, and a surfactant. Specific examples thereof include a cyano group-containing polyphenylene vinylene, a boron-containing polymer, bathocuproine, bathophenanthroline, hydroxyquinolinatoaluminum, an oxadiazole compound, a benzimidazole compound, a naphthalenetetracarboxylic acid compound, a fullerene compound, a perylene derivative, a phosphine oxide compound, a phosphine sulfide compound, a fluoro group-containing phthalocyanine, titanium oxide, zinc oxide, indium oxide, tin oxide, gallium oxide, tin sulfide, indium sulfide, and zinc sulfide.

A preferred lower limit of the thickness of the electron-transporting layer 4 is 1 nm, and a preferred upper limit thereof is 2,000 nm. When such thickness is 1 nm or more, a hole can be sufficiently blocked, and when the thickness is 2,000 nm or less, the electron-transporting layer 4 is less liable to serve as a resistance at the time of the electron transportation, and hence the photoelectric conversion efficiency is improved. A more preferred lower limit of the thickness is 3 nm, a more preferred upper limit thereof is 1,000 nm, a still more preferred lower limit thereof is 5 nm, and a still more preferred upper limit thereof is 500 nm.

### [Intermediate Layer]

The photoelectric conversion element 1 may include one or a plurality of intermediate layers 8 for the purpose of reducing an energy gap or the like that may become a hindrance to charge transfer, or suppressing migration between layers. The intermediate layer contains any one of an inorganic compound or an organic compound. Examples of the inorganic compound include an Al compound, a Mo compound, a Ni compound, a Ti compound, a Sn compound, and a Zn compound. Examples of the organic compound include a fullerene compound, a phthalocyanine compound, a spirofluorene compound, a triphenylamine compound, a chrysene compound, a pyrene compound, a phthalocyanine compound, a carbazole compound, a fluorene compound, a phenylcyclohexane compound, a benzidine compound, a phenoxazine compound, a phenylenediamine compound, a thiocyanate compound, a butyral resin, an acrylic resin, a polycarbonate resin, a polyester resin, a polyvinyl acetal resin, an epoxy resin, a melamine resin, a polyurethane resin, a phenol resin, a polyvinylphenol resin, an alkyd resin, a polyvinyl alcohol resin, a polyethylene oxide resin, a polypropylene oxide resin, a polyamide resin, a polyamic acid resin, a polyimide resin, a polyamide-imide resin, and a cellulose resin. Of those, a phthalocyanine compound is preferred because of its satisfactory compatibility with the compound represented by the general formula (1) of the present invention.

The thickness of the intermediate layer is preferably 5 to 800 nm. When the thickness is 5 nm or more, a suppressing effect on the migration between layers can be expected, and when the thickness is 800 nm or less, charge can be easily satisfactorily transported to the respective electrodes. The thickness is more preferably 40 to 600 nm, still more preferably 40 to 400 nm. In addition, the intermediate layer can also be expected to have a reducing effect on the energy gap or the like that may become a hindrance to charge transfer between layers.

### <Application Example>

Application examples of the present invention are directed to a photoelectric conversion apparatus, a moving body, and a building material.

### [Photoelectric Conversion Apparatus]

The photoelectric conversion apparatus of the present invention includes the photoelectric conversion element of the present invention. A photoelectric conversion apparatus may be formed by using a plurality of photoelectric conversion elements of the present invention. When the plurality of photoelectric conversion elements are connected, such photoelectric conversion apparatus may also be referred to as "photoelectric conversion cell" or "photoelectric conversion module." In the photoelectric conversion element, elements having different absorption wavelengths may be laminated to increase an output voltage. In addition, the photoelectric conversion apparatus includes the photoelectric conversion element of the present invention and an inverter. The inverter may be a converter for converting a DC voltage to an AC voltage.

The photoelectric conversion apparatus may include an electricity storage unit connected to the photoelectric conversion element. The electricity storage unit is not limited as long as the electricity storage unit can store electricity. Examples thereof include a secondary battery using lithium ions, an all-solid-state battery, and an electric double layer capacitor. In order to impart a function of, for example, maintaining or increasing the amount of incident light, a surface layer to which water or dirt is hard to adhere, or a function of collecting or guiding light may be added.

### [Moving Body]

The moving body of the present invention includes the photoelectric conversion element of the present invention. Fig. 3 is a perspective view for schematically illustrating a moving body including the photoelectric conversion element according to one embodiment of the present invention. A moving body 30 includes a photoelectric conversion element 31 and a body 32 including the photoelectric conversion element 31. The photoelectric conversion element of the present invention is applicable to the photoelectric conversion element 31. The photoelectric conversion element 31 is arranged on the position of the body 32 at which ambient light can be received. When the moving body 30 is an automobile, the photoelectric conversion element 31 may be arranged on a roof. Electric energy obtained by the photoelectric conversion element 31 may serve as the power of the moving body 30 or the power of any other electric equipment. Electric energy generated from the power of the moving body 30 may be used for the power of the photoelectric conversion element 31. When the moving body 30 is an automobile, friction energy generated with a brake may be converted into electric energy to be used for the control of the photoelectric conversion element 31.

The moving body 30 may be, for example, an automobile, a motorcycle, a railway vehicle, a ship, or a flying body including an artificial satellite, an airplane, and a drone. The configuration of the body 32 of the moving body 30 is not particularly limited, but is preferably formed of a material having high strength.

### [Building Material]

The building material of the present invention includes the photoelectric conversion element of the present invention. Fig. 4 is a perspective view for schematically illustrating a building material including the photoelectric conversion element according to one embodiment of the present invention. A building material 40 may be a roof of a building. The building material 40 of this embodiment includes a photoelectric conversion element 41, a protective member 42 for protecting the photoelectric conversion element 41, a heat dissipation member 43, and exteriors 44a and 44b. The photoelectric conversion element of the present invention is applicable to the photoelectric conversion element 41.

The building material 40 of the present invention may include the heat dissipation member 43 having a thermal conductivity higher than that of the photoelectric conversion element 41. When the building material 40 is used for a roof or the like, the temperature of the photoelectric conversion element 41 may be increased by sunlight, and hence the photoelectric conversion efficiency may be reduced. The reduction of the photoelectric conversion efficiency can be suppressed by using the heat dissipation member 43. Examples of the heat dissipation member 43 include a metal, an alloy, a liquid metal, and a liquid resin.

In addition, the building material 40 of the present invention may include the exteriors 44a and 44b. The exterior 44a and the exterior 44b may show different colors, or may show the same color. The exterior 44a and the exterior 44b may be formed of the same member, or may be formed of different members. A paint or a transparent substrate may be used as each of the exteriors. An exterior having small light absorption and a high heat-shielding property is preferred.

In addition to the application examples described above, the following application examples may be given: portable devices, such as a calculator, a sensor, and a small solar panel; wearable devices, such as a glasses-type terminal, a watch-type terminal, and a portable medical device; sheet structures supported by a plurality of frames, such as a tent, a plastic house, and a loading platform of a truck; and structures to be used by being fixed, such as a road surface panel, a floating panel, a building material utilizing the flexibility of a substrate, a wall-type building material, a glass-type building material, and a mega solar panel.

### [Method of producing Photoelectric Conversion Element]

A method of producing the photoelectric conversion element of the present invention includes the steps of: forming a first electrode; forming a second electrode; and forming a photoelectric conversion layer containing a crystal having a perovskite structure between the first electrode and the second electrode.

The respective steps of the production method are described below.

### [Step of forming First Electrode and Step of forming Second Electrode]

The method of producing a photoelectric conversion element of the present invention includes the steps of: forming the first electrode; and forming the second electrode. In the step of forming the first electrode and the step of forming the second electrode, an appropriate method may be selected in accordance with a material of the first electrode and a material of the second electrode, respectively. Examples of such method include, but are not limited to, a sputtering method, a vacuum vapor deposition method, a vapor phase growth method (CVD method), and a spray pyrolysis deposition method (SPD method). The materials of the first electrode and the second electrode are as described above. When one or both of the first electrode and the second electrode are transparent electrodes, the thickness of each of the transparent electrodes is preferably 0.03 to 3 µm.

When a solar cell is produced, cutting processing may be performed for circuit formation between steps. Examples of the cutting processing include mechanical patterning and laser patterning.

### [Modularization Step]

An element formed up to the electrode may be sealed. A sealing method is, for example, sealing with a resin or sealing with a film. Examples of a material used for the sealing include silazane, silicone rubber, resins each having a siloxane skeleton, and glass.

In addition, hairline treatment may be applied to the surface of the sealed element from the viewpoint of the suppression of adhesion between elements occurring during winding in a roll-to-roll system.

### [Step of forming Photoelectric Conversion Layer]

The step of forming the photoelectric conversion layer may include a step of applying a liquid containing the material of the photoelectric conversion layer as described above. Examples of an application method include a spin coating method, a blade coating method, a slit die coating method, a screen printing method, a bar coater method, a casting method, a printing transfer method, a dip-up method, an ink jet method, a spray method, and a vacuum vapor deposition method. The method is appropriately selected therefrom in accordance with the properties of a photoelectric conversion layer to be produced, such as thickness control and orientation control.

Annealing treatment may be performed under reduced pressure or in an inert atmosphere (in a nitrogen or argon atmosphere) in order to remove a solvent or a dispersion medium from the applied liquid containing the material of the photoelectric conversion layer. The temperature of the annealing treatment is preferably 40 to 300°C, more preferably 50 to 150°C. The annealing treatment is preferably performed because materials for forming the respective layers may permeate each other at an interface between laminated layers to increase a contact area, and hence a short-circuit current can be increased.

### [Step of forming Intermediate Layer]

The method of producing a photoelectric conversion element of the present invention may include a step of forming an intermediate layer between the photoelectric conversion layer and the first electrode.

Examples of the step of forming the intermediate layer include: a method including arranging a charge-transporting particle on the surface of the photoelectric conversion layer, and then applying and drying a resin solution in which an insulating resin is dissolved; a method including applying the resin solution in which the insulating resin is dissolved on the surface of the photoelectric conversion layer, then arranging the charge-transporting particle thereon, and then drying the resin solution; and a method including applying a solution obtained by dispersing the charge-transporting particle in the resin solution in which the insulating resin is dissolved onto the surface of the photoelectric conversion layer and drying the applied solution.

### [Examples]

The present invention is specifically described below by way of Examples with reference to the drawings. However, the present invention is not limited to the following Examples. The identification of compounds obtained in Synthesis Examples was performed by ¹H-NMR measurement (apparatus: AVANCE 3-500, manufactured by BRUKER).

### (Synthesis Example 1) Synthesis of Compound (A-8)

2,7-Dibromofluorenone (1.69 g, manufactured by Tokyo Chemical Industry Co., Ltd.), 4-methoxy-4'-methyldiphenylamine (2.16 g, manufactured by Tokyo Chemical Industry Co., Ltd.), and toluene (100 mL) were loaded into a reaction vessel, and deaeration was performed for 30 minutes. Xphos (0.21 g, manufactured by Sigma-Aldrich Co. LLC), tris(dibenzylideneacetone)dipalladium(0) (0.28 g, manufactured by Tokyo Chemical Industry Co., Ltd.), and sodium t-butoxide (1.40 g, manufactured by Tokyo Chemical Industry Co., Ltd.) were loaded into the reaction vessel, and the mixture was stirred under heating and refluxing for 24 hours under a nitrogen atmosphere. After the completion of the reaction, the mixture was filtered with ethyl acetate through use of activated clay. The filtrate was concentrated, and the crude product was purified by silica gel column chromatography (hexane:ethyl acetate=7:1) to provide a compound represented by the following formula (A-8) as blackish purple powder (yield: 1.79 g, percent yield: 59%). The results of the identification of the resultant compound represented by the following formula (A-8) by the ¹H-NMR measurement are shown below. ¹H-NMR (500 MHz, CDCl₃): δ (ppm)=7.14 (2H), 7.08 (2H), 6.98 (4H), 6.96 (4H), 6.93 (2H), 6.88 (8H), 6.76 (8H), 3.73 (6H), 2.24 (6H).

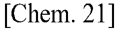

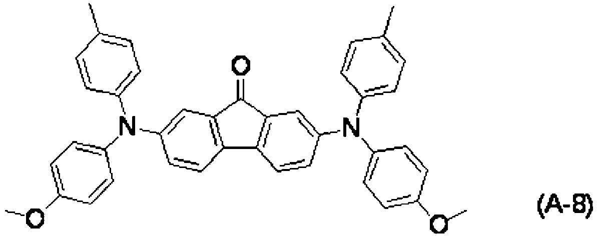

### (Synthesis Example 2) Synthesis of Compound (B-1) used in Comparative Example

2,7-Dibromofluorenone (1.69 g, manufactured by Tokyo Chemical Industry Co., Ltd.), bis-(4-methoxyphenyl)-[4-(4,4,5,5-tetramethyl-[1,3,2]dioxaborolan-2-yl)-phenyl]-amine (3.34 g, manufactured by Tokyo Chemical Industry Co., Ltd.), toluene (28 mL), ethanol (9.5 mL), and water (9.0 mL) were loaded into a reaction vessel, and deaeration was performed for 30 minutes. Tetrakis(triphenylphosphine)palladium(0) (0.24 g, manufactured by Tokyo Chemical Industry Co., Ltd.) and potassium carbonate (1.83 g, manufactured by Nippon Soda Co., Ltd.) were loaded into the reaction vessel, and the mixture was stirred at 100°C for 24 hours under a nitrogen atmosphere. After the completion of the reaction, the mixture was extracted with ethyl acetate, washed with a saturated aqueous sodium chloride solution, and then dried over sodium sulfate. After concentration, the crude product was purified by silica gel column chromatography (hexane:ethyl acetate=7:1) to provide a compound represented by the following formula (B-1) as blackish purple powder (yield: 1.97 g, percent yield: 50%). The results of the identification of the resultant compound represented by the following formula (B-1) by the ¹H-NMR measurement are shown below. ¹H-NMR (500 MHz, CDCl₃): δ (ppm)=7.79 (2H), 7.60 (2H), 7.45 (2H), 7.37 (4H), 7.03 (8H), 6.91 (4H), 6.79 (8H), 3.74 (12H).

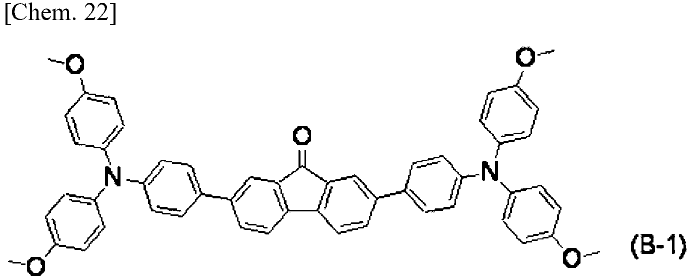

### (Synthesis Example 3) Synthesis of Compound (B-2) used in Comparative Example

2,7-Dibromofluorenone (1.70 g, manufactured by Tokyo Chemical Industry Co., Ltd.), 4,4'-dimethoxydiphenylamine (2.35 g, manufactured by Nard Institute, Ltd.), and toluene (100 mL) were loaded into a reaction vessel, and deaeration was performed for 30 minutes. 1,1'-Bis(diphenylphosphino)ferrocene (0.17 g, manufactured by Sigma-Aldrich Co. LLC), palladium(0) acetate (0.048 g, manufactured by Tokyo Chemical Industry Co., Ltd.), and cesium carbonate (4.90 g, manufactured by Tokyo Chemical Industry Co., Ltd.) were loaded into the reaction vessel, and the mixture was stirred under heating and refluxing for 24 hours under a nitrogen atmosphere. After the completion of the reaction, the mixture was filtered with ethyl acetate through use of activated clay. The filtrate was concentrated, and the crude product was purified by silica gel column chromatography (hexane:ethyl acetate=4:1) to provide a compound represented by the following formula (B-2) as blackish purple powder (yield: 1.44 g, percent yield: 45%). The results of the identification of the resultant compound represented by the following formula (B-2) by the ¹H-NMR measurement are shown below. ¹H-NMR (500 MHz, CDCl₃): δ (ppm)=7.17 (2H), 7.13 (2H), 7.02 (8H), 6.94 (2H), 6.83 (8H), 3.80 (12H).

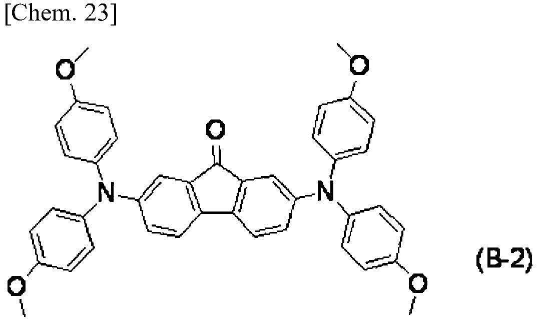

The present invention is described in more detail below by way of Examples and Comparative Examples. The present invention is by no means limited to the following Examples without departing from the gist thereof. In the following description of Examples, the term "part(s)" is by mass unless otherwise specified.

### <Production of Particle 1>

### Step (1)

Under a nitrogen flow atmosphere, 5.46 parts of orthophthalonitrile and 45 parts of α-chloronaphthalene were loaded into a reaction kettle. After that, the mixture was heated so that its temperature was increased to 30°C, followed by the maintenance of the temperature. Next, 3.75 parts of gallium trichloride was loaded into the reaction kettle at the temperature (30°C). The moisture concentration of the mixed liquid at the time of the loading was 150 ppm. After that, the temperature of the mixed liquid was increased to 200°C. Next, under a nitrogen flow atmosphere, the mixed liquid was subjected to a reaction at a temperature of 200°C for 4.5 hours, and was then cooled. The product was filtered when its temperature reached 150°C. The resultant filter residue was subjected to dispersion washing with N,N-dimethylformamide at a temperature of 140°C for 2 hours, and was then filtered. The resultant filter residue was washed with methanol, and was then dried to provide a chlorogallium phthalocyanine particle in a percent yield of 71%.

### Step (2)

4.65 Parts of the chlorogallium phthalocyanine particle was dissolved in 139.5 parts of concentrated sulfuric acid at a temperature of 10°C, and the solution was dropped into 620 parts of ice water under stirring so that the particle was reprecipitated, followed by filtration with a filter press under reduced pressure. At this time, No. 5C (manufactured by Advantec Toyo Kaisha, Ltd.) was used as a filter. The resultant wet cake (filter residue) was subjected to dispersion washing with 2% ammonia water for 30 minutes, and was then filtered with the filter press. Next, the resultant wet cake (filter residue) was subjected to dispersion washing with ion-exchanged water, and then its filtration with the filter press was repeated three times. Finally, the filter residue was freeze-dried to provide a hydroxygallium phthalocyanine particle (hydrous hydroxygallium phthalocyanine particle) having a solid content of 23 mass% in a percent yield of 71%. The hydroxygallium phthalocyanine particle was dried with a hyper-dry dryer (product name: HD-06R, frequency (oscillatory frequency): 2,455 MHz±15 MHz, manufactured by Biocon (Japan) Ltd.). Thus, a hydroxygallium phthalocyanine particle (crystal) having a water content of 1.0 mass% or less was obtained.

### Step (3)

5 Parts of the hydroxygallium phthalocyanine particle was subjected to dispersion treatment for 6 hours with a sand mill (TSG-1/4G-4U, manufactured by Igarashi Machine Production Co., Ltd. (currently AIMEX Co., Ltd.), disc diameter: 70 mm, number of discs: 5) containing 5 parts of an N-methylformamide solvent and 5 parts of glass beads, followed by filtration and drying to provide a particle 1.

### <Production of Resin Solution 1>

1.0 Gram of polyvinyl butyral (product name: BM-2, manufactured by Sekisui Chemical Co., Ltd.) was dissolved in 19 g of 2-propanol by stirring for 24 hours to provide a resin solution 1.

### (Example 1)

### [Formation of Electron-transporting Layer]

A glass substrate with ITO was washed, and tin(II) oxide adjusted to 3 mass% was applied thereonto by spin coating, followed by heating at 150°C for 30 minutes to form an electron-transporting layer as a thin film having a thickness of 15 nm.

### [Formation of Photoelectric Conversion Layer]

0.41 Grams of formamidinium iodide, 1.2 g of lead iodide, 0.05 g of methylammonium bromide, and 0.17 g of lead bromide were dissolved in 1.67 g of N,N-dimethylformamide and 0.49 g of dimethyl sulfoxide, and the mixture was stirred at 70°C for 24 hours. After that, a cesium iodide solution in which 0.035 g of cesium iodide was dissolved in 0.1 g of dimethyl sulfoxide was added to the mixture to prepare a photoelectric conversion layer coating liquid. The coating liquid was applied onto the electron-transporting layer by spin coating to form a photoelectric conversion layer formed of Cs_{0.05}(MA_{0.17}FA_{0.83})_{0.95}Pb(I_{0.83}Br_{0.17})₃ and having a thickness of 500 nm.

### [Introduction of Hole-transporting Layer]

0.075 Grams of the compound (A-8) serving as a hole-transporting material obtained in Synthesis Example 1 was dissolved in 1.1 g of chlorobenzene to prepare a hole-transporting material solution. The solution was applied onto the above-mentioned photoelectric conversion layer by a spin coating method to form a hole-transporting layer having a thickness of 300 nm.

### [Formation of First Electrode]

A gold electrode having a thickness of 80 nm and an area of 0.09 cm² was formed on the hole-transporting layer by a vacuum vapor deposition method to form a first electrode. Thus, a photoelectric conversion element was obtained.

### [Analysis of Thickness]

A thickness was determined with a cross-sectional SEM (apparatus: SmartSEM manufactured by Carl Zeiss Co., Ltd.) after the cutting of the photoelectric conversion element and the fixing of the sample to a tilted sample stage.

### (Example 2)

A photoelectric conversion element is obtained in the same manner as in Example 1 except that the compound (A-12) is used for the hole-transporting layer.

### (Example 3)

A photoelectric conversion element is obtained in the same manner as in Example 1 except that the compound (A-14) is used for the hole-transporting layer.

### (Example 4)

A photoelectric conversion element is obtained in the same manner as in Example 1 except that the compound (A-16) is used for the hole-transporting layer.

### (Example 5)

A photoelectric conversion element is obtained in the same manner as in Example 1 except that the compound (A-23) is used for the hole-transporting layer.

### (Example 6)

A photoelectric conversion element was obtained in the same manner as in Example 1 except that an intermediate layer described below was arranged between the photoelectric conversion layer and the hole-transporting layer.

### [Formation of Intermediate Layer]

0.1 Grams of the particle 1, 0.01 g of a calixarene compound (Japanese Patent Laid-Open No. 2003-207913), 10.6 g of 2-propanol, and 11 g of zirconia beads were loaded, and the materials were dispersed with a paint shaker (manufactured by Toyo Seiki Seisaku-sho, Ltd.) for 6 hours. After that, 0.2 g of the resin solution 1 was added thereto, and the materials were dispersed with the paint shaker again for 6 hours to prepare a charge-transporting solution. The charge-transporting solution was applied onto the photoelectric conversion layer by spin coating to form an intermediate layer having a thickness of 150 nm.

### [Analysis of Amount of Compound]

The electrode surface of the photoelectric conversion element was peeled off so that the surface of the intermediate layer was exposed. The surface of the intermediate layer was wiped with a cotton swab or the like with a solvent, dissolved in deuterated sulfuric acid, and subjected to ¹H-NMR measurement (apparatus: AVANCE 3-500, manufactured by BRUKER). In addition, the presence of a compound was recognized by subjecting the peeled-off components to mass and structure analyses using GPC and MALDI-TOF-MS, IR, and gas chromatography.

### (Comparative Example 1)

A photoelectric conversion element was obtained in the same manner as in Example 1 except that the compound (B-1) obtained in Synthesis Example 2 was used for the hole-transporting layer.

### (Comparative Example 2)

A photoelectric conversion element was obtained in the same manner as in Example 1 except that the compound (B-2) obtained in Synthesis Example 3 was used for the hole-transporting layer.

### [Evaluations]

The photoelectric conversion element obtained in each of Examples and Comparative Examples was subjected to the following evaluations.

### (Power Generation Efficiency Evaluation)

A power supply (236 model, manufactured by Keithley Instruments) was connected between the electrodes of the photoelectric conversion element, and its photoelectric conversion efficiency was evaluated by: irradiating the element with constant light through use of a solar simulator (manufactured by Yamashita Denso Corporation) having an intensity of 100 mW/cm²; and measuring the generated current and voltage.

### (Hysteresis Evaluation)

A hysteresis index (HI) was calculated from the following formula (9) by using PCE_{for.} and PCE_{rev.}, which were values obtained by evaluating the photoelectric conversion efficiency (PCE) obtained by the above-mentioned measurement for the respective voltage application directions. It can be said that a smaller HI indicates smaller hysteresis.
[Math. 1] $HI = \frac{{PCE}_{rev .} - {PCE}_{for .}}{{PCE}_{rev .}}$ (9)

The results are shown in Table 3.

### [Table 3]

**Table 3**

| | Hole-transporting material | Short-circuit current density J_{SC} [mA/cm²] | Open-circuit voltage V_{OC} [V] | Photoelectric conversion efficiency PCE [%] | Hysteresis index HI |
|---|---|---|---|---|---|
| Example 1 | A-8 | 13.3 | 1.05 | 4.28 | 0.127 |
| Example 2 | A-12 | 13.6 | 1.00 | 3.34 | 0.101 |
| Example 3 | A-14 | 13.1 | 1.13 | 3.18 | 0.098 |
| Example 4 | A-16 | 13.2 | 1.01 | 3.11 | 0.156 |
| Example 5 | A-23 | 13.1 | 1.04 | 2.82 | 0.142 |
| Example 6 | A-8 | 12.0 | 1.04 | 3.85 | 0.039 |
| Comparative Example 1 | B-1 | 5.40 | 1.11 | 1.21 | 0.185 |
| Comparative Example 2 | B-2 | 9.52 | 1.09 | 1.96 | 0.179 |

The present invention is not limited to the embodiments described above, and various changes and modifications may be made without departing from the spirit and scope of the present invention. The following claims are appended hereto in order to make the scope of the present invention public.

The present application claims priority based on Japanese Patent Application No. 2023-216293 filed on December 21, 2023, and Japanese Patent Application No. 2024-086008 filed on May 28, 2024, and the entire contents thereof are incorporated herein by reference.

### [Reference Signs List]

1 photoelectric conversion element
2 substrate
3 second electrode
4 electron-transporting layer
5 photoelectric conversion layer
6 hole-transporting layer
7 first electrode

## Claims

1. A photoelectric conversion element comprising:
a first electrode;
a second electrode; and
a photoelectric conversion layer arranged between the first electrode and the second electrode, the photoelectric conversion layer containing a crystal having a perovskite structure,
wherein the photoelectric conversion element comprises, between the photoelectric conversion layer and the first electrode, a hole-transporting layer containing a compound represented by the following formula (1): 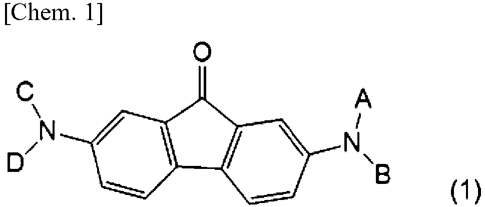 in the formula (1), A represents 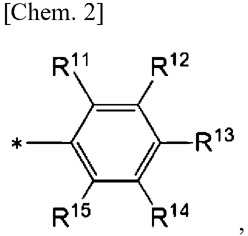 B represents 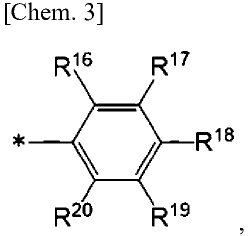 C represents 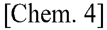 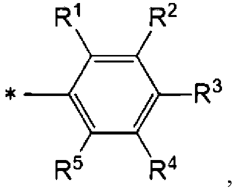 and D represents 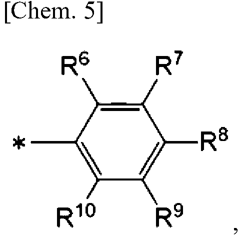 and R¹ to R²⁰ in the A to the D each independently represent a hydrogen atom, a trimethylsilyl group, a linear or branched alkyl group having 1 to 20 carbon atoms that may have a substituent, a linear or branched alkenyl group having 2 to 20 carbon atoms that may have a substituent, a cycloalkyl group having 3 to 10 carbon atoms that may have a substituent, an alkoxy group having 1 to 20 carbon atoms that may have a substituent, a cycloalkoxy group having 3 to 10 carbon atoms that may have a substituent, an alkylthio group or arylthio group having 1 to 18 carbon atoms that may have a substituent, a (di)alkylamino group or (di)arylamino group having 1 to 20 carbon atoms that may have a substituent, an aromatic hydrocarbon group having 6 to 36 carbon atoms that has a substituent, or a heterocyclic group having 5 to 36 ring-forming atoms that may have a substituent, and * in each of the formulae represents a bonding position with the formula (1), provided that the A and the B are different from each other, and the C and the D are different from each other.

2. The photoelectric conversion element according to claim 1, wherein the hole-transporting layer contains a compound represented by the formula (1) in which the A and the B are different from each other, the C and the D are different from each other, the A and the C are identical to each other, and the B and the D are identical to each other.

3. The photoelectric conversion element according to claim 1 or 2, wherein the hole-transporting layer contains a compound represented by the formula (1) in which R¹ to R²⁰ in the A to the D each independently represent a hydrogen atom, a linear or branched alkyl group having 1 to 20 carbon atoms that may have a substituent, an alkoxy group having 1 to 20 carbon atoms that may have a substituent, a (di)alkylamino group or (di)arylamino group having 1 to 20 carbon atoms that may have a substituent, or an alkylthio group or arylthio group having 1 to 18 carbon atoms that may have a substituent.

4. The photoelectric conversion element according to any one of claims 1 to 3, wherein the hole-transporting layer contains a compound represented by the formula (1) in which the A to the D each have, at one position of an ortho position or a para position, one kind of a hydrogen atom, a linear or branched alkyl group having 1 to 20 carbon atoms that may have a substituent, an alkoxy group having 1 to 20 carbon atoms that may have a substituent, a (di)alkylamino group or (di)arylamino group having 1 to 20 carbon atoms that may have a substituent, or an alkylthio group or arylthio group having 1 to 18 carbon atoms that may have a substituent.

5. The photoelectric conversion element according to any one of claims 1 to 4, wherein, in the formula (1),
when a phenyl group in the A is free of a substituent, a phenyl group in the B has a linear or branched alkyl group having 1 to 20 carbon atoms that may have a substituent, an alkoxy group having 1 to 20 carbon atoms that may have a substituent, a (di)alkylamino group or (di)arylamino group having 1 to 20 carbon atoms that may have a substituent, or an alkylthio group or arylthio group having 1 to 18 carbon atoms that may have a substituent,
when the phenyl group in the A has a linear or branched alkyl group having 1 to 20 carbon atoms that may have a substituent, the phenyl group in the B has an alkoxy group having 1 to 20 carbon atoms that may have a substituent, a (di)alkylamino group or (di)arylamino group having 1 to 20 carbon atoms that may have a substituent, or an alkylthio group or arylthio group having 1 to 18 carbon atoms that may have a substituent,
when the phenyl group in the A has a linear or branched alkoxy group having 1 to 20 carbon atoms that may have a substituent, the phenyl group in the B has a (di)alkylamino group or (di)arylamino group having 1 to 20 carbon atoms that may have a substituent, and
when the phenyl group in the A has an alkylthio group or arylthio group having 1 to 18 carbon atoms that may have a substituent, the phenyl group in the B has a (di)alkylamino group or (di)arylamino group having 1 to 20 carbon atoms that may have a substituent.

6. The photoelectric conversion element according to any one of claims 1 to 5, wherein the compound represented by the formula (1) is any one selected from the group consisting of: a compound represented by the following formula (A-8); a compound represented by the following formula (A-12); a compound represented by the following formula (A-14); a compound represented by the following formula (A-16); and a compound represented by the following formula (A-23).

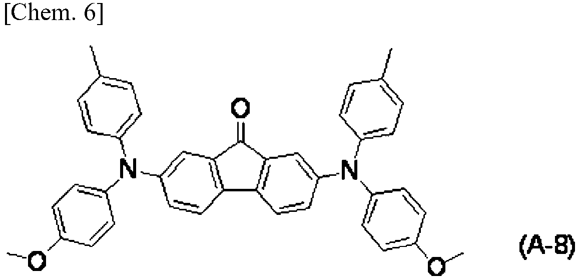

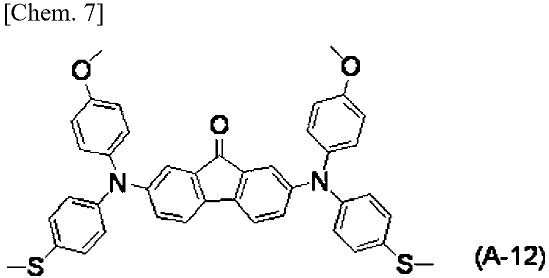

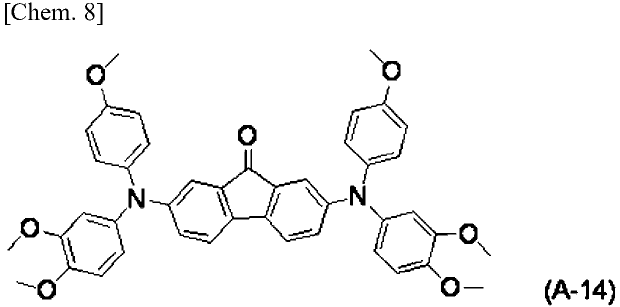

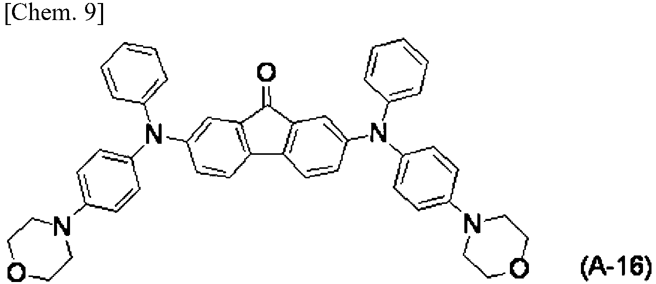

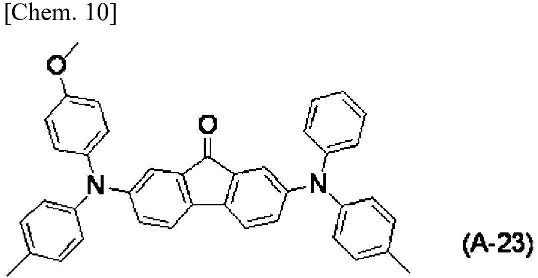

7. The photoelectric conversion element according to any one of claims 1 to 6, further comprising an intermediate layer containing a phthalocyanine particle between the hole-transporting layer and the photoelectric conversion layer.

8. A photoelectric conversion apparatus comprising the photoelectric conversion element of any one of claims 1 to 7.
